# EUROPÄISCHE PATENTSCHRIFT

(11) **EP 3 474 026 B1**
(45) Veröffentlichungstag und Bekanntmachung des Hinweises auf die Patenterteilung: **31.12.2025**
(21) Anmeldenummer: 18201163.5
(22) Anmeldetag: 18.10.2018
(51) Int. Cl.: G01R 15/20, H01H 9/10, H01H 1/20, G01R 31/364, H01H 85/02

(54) **KONTAKTANORDNUNG MIT STROMMESSEINRICHTUNG**
CONTACT ARRANGEMENT WITH CURRENT MEASUREMENT DEVICE
DISPOSITIF DE CONTACT AVEC DISPOSTIF DE MESURE DE COURANT

(30) Priorität: 23.10.2017 DE 102017124642
(43) Veröffentlichungstag der Anmeldung: 24.04.2019
(73) Patentinhaber: TE Connectivity KISSLING Products GmbH, 72218 Wildberg (DE)
(72) Erfinder: KALMBACH, Simon, 72213 Altensteig (DE)
(74) Vertreter: Grünecker Patent- und Rechtsanwälte PartG mbB

(56) Entgegenhaltungen:
- EP-A1- 0 867 725
- EP-A1- 2 383 763
- WO-A1-99/36928
- DE-A1- 102012 201 514
- DE-A1- 102015 218 290
- US-A1- 2016 211 087
- US-A1- 2017 279 261

## Beschreibung

Die Erfindung betrifft eine Kontaktanordnung auf einer Leiterplatte mit zwei Hauptkontaktanschlüssen, die über eine stromleitende Brücke verbunden sind, und mit einer Strommesseinrichtung zur Messung mindestens des über die Hauptkontaktanschlüsse fließenden Stroms.

Solche Kontaktanordnungen sind insbesondere auf Leistungsplatinen vorgesehen, die beispielsweise zur Zu- und Abschaltung von Batterien in Nutzfahrzeugen eingesetzt werden. Um Fehlfunktionen der Elektronik zu vermeiden, müssen die über die Kontakte fließenden Ströme gemessen werden. Jedes Bauelement auf einer Leiterplatine beansprucht jedoch Einbauraum und Leiterbahnenanschlüsse zu den übrigen Komponenten. Häufig sind die Platzverhältnisse auf den Platinen aber begrenzt, da deren Größe nicht beliebig erweitert werden kann, sondern einem bestimmten Einbauraum im Fahrzeug angepasst sein muss.

EP 2 383 763 A1 bezieht sich auf ein Relais mit mindestens einer Spule und einem beweglichen Anker, der durch den in der mindestens einen Spule erzeugbaren magnetischen Fluss einen Stromfluss über zwei Hauptkontaktanschlüsse zulässt oder unterbricht, und mit einer Strommesseinrichtung zur Messung mindestens des über die Hauptkontaktanschlüsse fließenden Stroms mittels mindestens eines Hall-Sensors.

DE 10 2015 218290 A1 betrifft eine Vorrichtung zum Messen eines elektrischen Stromflusses, umfassend eine Leiterplatte, eine Sensorkomponente zum Detektieren von Magnetfeldern, wobei die Sensorkomponente auf einer Oberfläche der Leiterplatte angeordnet ist, und ein leitendes Element zum Leiten des Hoch-/Mittel- /Niederspannungsstroms, der gemessen werden soll.

EP 0 867 725 A1 betrifft einen Stromdetektor, insbesondere einen Stromsensor, der durch die Integration mit einem Leiter gebildet wird, durch den der zu messende Strom fließt.

US 2017/279261 A1 bezieht sich auf eine Strommesseinrichtung mit zwei oder mehr Stromsensoren. Mindestens zwei der Stromsensoren können unterschiedliche Strommessbereiche und unterschiedliche Strommessempfindlichkeiten aufweisen.

WO 99/36928 A1betrifft einen Leistungsschalter mit Halleffektsensoren.

Der Erfindung liegt daher die Aufgabe zugrunde, eine Kontaktanordnung zu schaffen, die einen nur geringen Einbauraum auf einer Leiterplatte benötigt.

Die Aufgabe wird gelöst durch eine Kontaktanordnung auf einer Leiterplatte mit zwei Hauptkontaktanschlüssen, die über eine stromleitende Brücke verbunden sind, und mit einer Strommesseinrichtung zur Messung mindestens des über die Hauptkontaktanschlüsse fließenden Stroms, wobei die Strommesseinrichtung (15) zwischen der stromleitenden Brücke (14) und der Leiterplatte angeordnet ist Die Platzierung der Strommesseinrichtung zwischen der stromleitenden Brücke und der Leiterplatte erfordert somit keinen zusätzlichen Einbauraum für die Strommesseinrichtung auf der Oberfläche der Leiterplatte. Auch eine vom beanspruchten Gegenstand nicht umfasste

Anordnung der Strommesseinrichtung auf der Leiterplattenrückseite ist denkbar, wobei diese Lösung jedoch zumindest auf der Leiterplattenrückseite ebenfalls einen Abschnitt der Leiterplattenoberfläche beansprucht. Vom Flächenverbrauch ist daher eindeutig die beanspruchte

Anordnung der Strommesseinrichtung zwischen der stromführenden Brücke und der Leiterplatte die beste Lösung.

Die Strommesseinrichtung weist mindestens einen Hall-Sensor auf. Die Verwendung von Hall -Sensoren zur Strommessung erlaubt es, die fließenden Ströme nicht direkt messen zu müssen, sondern indirekt, d. h. galvanisch getrennt über das durch den Strom induzierte Magnetfeld erfassen zu können.

Die Strommesseinrichtung weist eine Einrichtung zur Ausrichtung des magnetischen Flusses auf, die mindestens einen die Hauptkontaktanschlüsse umschließenden und mit einem Freiraum für den oder die Hall -Sensoren versehenen ferromagnetischen Körper aufweist. Durch die Bündelung des magnetischen Feldes können Einflüsse anderer, auf der Leiterplatte angeordneter und ein Magnetfeld erzeugender Bauteile eliminiert werden. Der magnetische Fluss wird auf den oder die Hall -Sensoren konzentriert. Dabei ist das Magnetfeld in dem Freiraum des ferromagnetischen Körpers für den oder die Hall -Sensoren besonders hoch, wodurch sich eine sehr hohe Genauigkeit der Strommesseinrichtung ergibt.

Der ferromagnetische Körper kann vorzugsweise aus einem Stapel von ferromagnetischen Flächen gebildet sein. Durch die Aufteilung des ferromagnetischen Körpers in einen Stapel einzelner Bleche, die jeweils identisch geformt sein können, kann die Remanenz des ferromagnetischen Körpers deutlich reduziert werden.

Bei der Kontaktanordnung ist in der stromleitenden Brücke eine Sicherung angeordnet, die den Stromfluss über die Brücke unterbricht, wenn die Stromstärke einen vorgegebenen Maximalwert überschreitet. Insbesondere, wenn die Kontaktanordnung Teil einer Schaltung zur Unterbrechung der Verbindung zu einer Batterie ist, kann eine solche Sicherung zum selbsttätigen Abschalten der Batterie führen, bevor empfindlichere Bauteile durch zu hohe Stromspitzen Schaden erleiden. Eine solche Sicherung ist insbesondere bei Hochstrom-Anwendungen erforderlich. Vorzugsweise können daher die Maximalwerte für die Stromstärke zwischen 40 A und 500 A betragen.

Das Messsignal des Hall-Sensors kann ebenfalls dazu benutzt werden, das Relais abzuschalten. Dadurch entsteht ein schnellerer und präziserer Leistungsschutz als über die Sicherung.

In die Kontaktanordnung kann außerdem ein Mikrokontroller integriert sein, der den vom Hall-Sensor gemessenen Strom digital weiterverarbeiten und an ein Bordnetz eines Fahrzeugs übermitteln kann.

Weiter ist es zweckmäßig, wenn zwischen der Strommesseinrichtung und der Leiterplatte ein elastischer Pufferkörper angeordnet ist. Der Pufferkörper dient der Fixierung des ferromagnetischen Körpers und dem Schutz des Hall-Sensors vor Verschmutzungen.

Bei einer besonders vorteilhaften Ausgestaltung sind die Hauptkontaktanschlüsse durch Bolzen gebildet, die über eine Einpress-Verbindung auf der Leiterplatte befestigt sind. Die Einpress-Verbindungen können durch einfaches Zusammenfügen der Bolzen mit der Leiterplatte unter Druck hergestellt werden. Eine aufwendige Verdrahtung und Lötvorgänge können daher entfallen. Es entsteht eine robuste mechanische Verbindung zwischen den Bolzen und der Leiterplatte.

Dabei können weitere Vorteile erzielt werden, wenn die Bolzen einen gestuften Durchmesser aufweisen, wobei ein unterer Bolzenabschnitt einen größeren Durchmesser aufweist als ein oberer Abschnitt. Auf diese Weise lassen sich die Bolzen gleichzeitig als Halteelemente für die stromführende Brücke und die Strommesseinrichtung einsetzen. Dabei kann die stromleitende Brücke vorzugsweise auf den unteren Bolzenabschnitten aufliegen und die Strommesseinrichtung zwischen den unteren Bolzenabschnitten angeordnet sein. Die Stufe der Bolzen zwischen den unteren und oberen Abschnitten dient somit als Auflage für die stromleitende Brücke. Der unter der stromleitenden Brücke vorhandene Hohlraum zwischen den unteren Bolzenabschnitten bildet den Einbauraum für die Strommesseinrichtung.

Für eine einfache Befestigung und Kontaktierung der die Abschlusskontakte bildenden Bolzen können die Brücke und/oder die Strommesseinrichtung Durchtrittsöffnungen zur Aufnahme und Kontaktierung der Bolzen aufweisen. Dadurch können die Strommesseinrichtung und die stromführende Brücke mit ihren Durchgangsöffnungen auf die Bolzen aufgesetzt werden. Sind die Bolzen außerdem zumindest in ihrem oberen Bereich mit einem Gewinde versehen, so kann die stromführende Brücke und/oder die Strommesseinrichtung mit Hilfe einer Mutter mechanisch an den Bolzen befestigt und gleichzeitig ein leitender Kontakt zu den Bolzen hergestellt werden.

Bei einer bevorzugten Ausgestaltung weisen die Bolzen einen rechteckigen oder quadratischen unteren Abschnitt und einen runden, mit einem Gewinde versehenen oberen Abschnitt auf. Die Strommesseinrichtung kann dann mit zwei rechteckigen oder quadratischen Öffnungen versehen und auf die unteren Bolzenabschnitte aufgesetzt werden. Anschließend wird die stromleitende Brücke, die zwei runde Öffnungen aufweist, auf die oberen Abschnitte aufgesetzt und mit Hilfe von Gewindemuttern an den Bolzen befestigt.

Bevorzugt können mit der Strommesseinrichtung außerdem Ströme in beide Stromrichtungen gemessen werden. Dadurch lassen sich die Anschlussmöglichkeiten der Kontaktanordnung erweitern.

Nachfolgend wird ein bevorzugtes Ausführungsbeispiel einer erfindungsgemäßen Kontaktanordnung mit Bezug auf die Zeichnung im Detail beschrieben.

Dabei zeigen:
- Fig. 1: eine Draufsicht auf eine Leiterplatte mit einer erfindungsgemäßen Kontaktanordnung;
- Fig. 2: eine vergrößerte Schnittdarstellung durch die Kontaktanordnung aus Fig. 1;
- Fig. 3: eine Detailansicht einer Strommesseinrichtung der Kontaktanordnung aus Fig. 1;
- Fig. 4: eine Explosionszeichnung der Strommesseinrichtung der Kontaktanordnung aus Fig. 1.

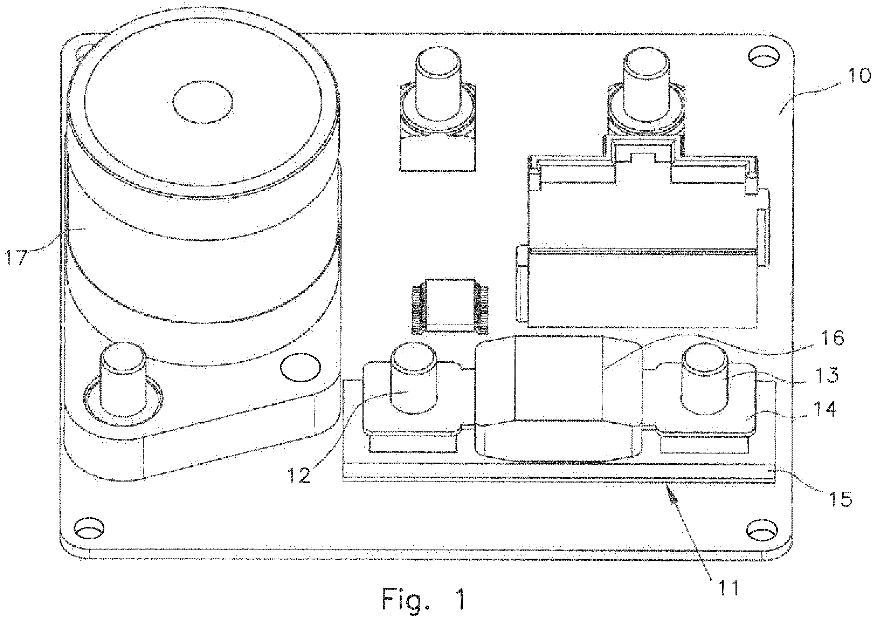

Fig. 1 zeigt eine Leiterplatte 10, auf der eine erfindungsgemäße Kontaktanordnung 11 angeordnet ist. Diese besteht aus zwei Hauptkontaktanschlüssen 12, 13, die über eine stromleitende Brücke 14 miteinander verbunden sind. Unterhalb der stromleitenden Brücke 14 ist eine Strommesseinrichtung 15 angeordnet, die ebenso wie die Strom leitende Brücke 14 mechanisch und elektrisch mit den Hauptkontaktanschlüssen 12, 13 gekoppelt ist. Die stromleitende Brücke 14 trägt außerdem eine Sicherung 16, die bei Überschreiten einer vorgegebenen Maximalstromstärke den Stromfluss über die Strom leitende Brücke 14 unterbricht. Damit kann beispielsweise ein ebenfalls auf der Leiterplatte 11 angeordnetes Relais 17 vor Beschädigungen geschützt werden.

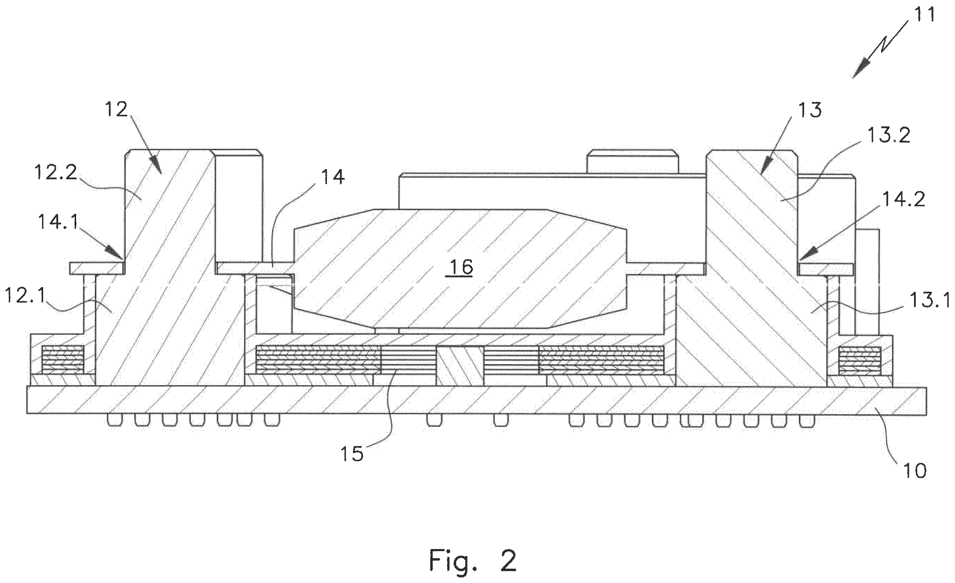

Wie die Schnittdarstellung durch die Kontaktanordnung 11 aus Fig. 2 zeigt, werden die Hauptkontaktanschlüsse 12, 13 jeweils von einem Bolzen gebildet, der über eine Press-Fit-Verbindung mit der Leiterplatte 10 verbunden ist. Die Schnittdarstellung verdeutlicht, dass die Hauptkontaktanschlüsse 12, 13 jeweils einen unteren Abschnitt 12.1, 13.1 und einen oberen Abschnitt 12.2, 13.2 aufweisen, wobei die unteren Abschnitte 12.1, 13.1 einen größeren Durchmesser aufweisen als die oberen Abschnitte 12.2, 13.2. Die Stufen zwischen den Abschnitten 12.1, 12.2 bzw. 13.1, 13.2 bilden somit eine Auflage für die stromleitende Brücke 14, die mit Durchgangsöffnungen 14.1, 14.2 versehen ist, mit denen sie auf die Hauptkontaktanschlüsse 12, 13 aufsetzbar ist.

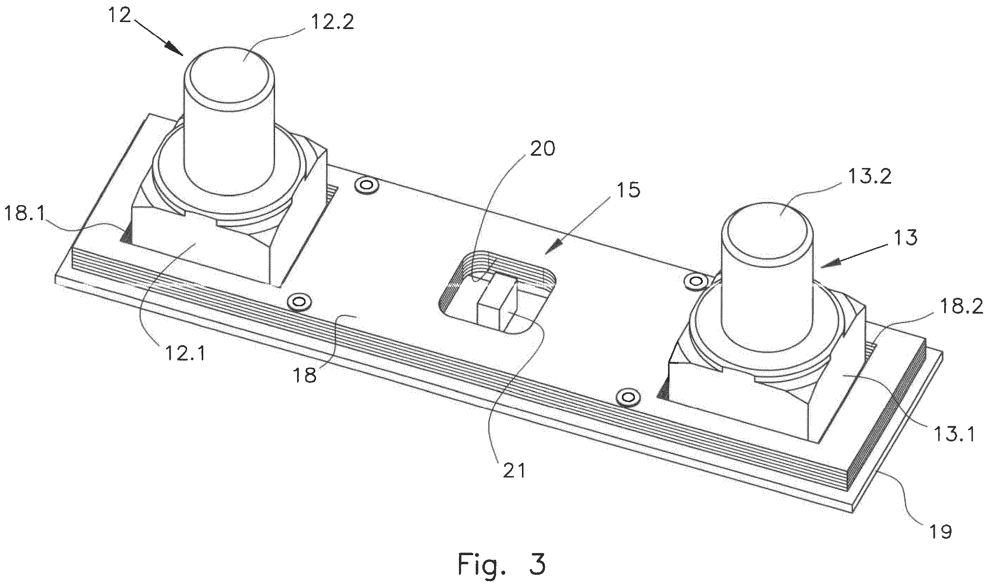

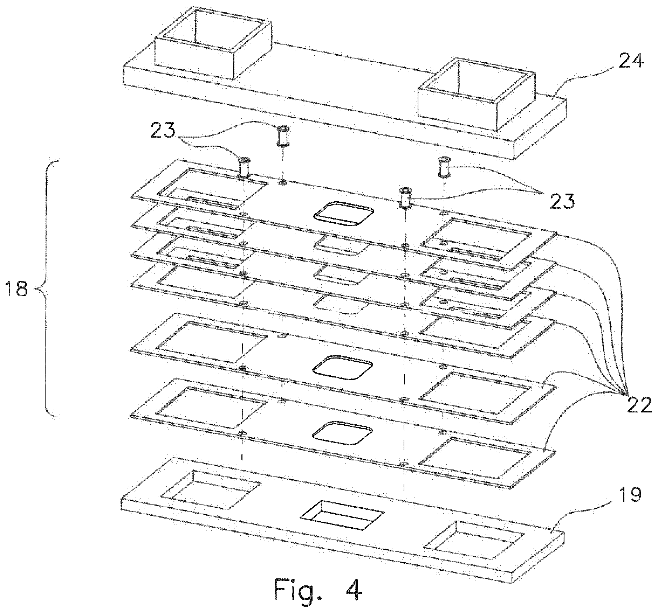

Unterhalb der stromleitenden Brücke 14 und der Sicherung 16 ist die Strommesseinrichtung 15 angeordnet, deren genauerer Aufbau in den Fig. 3 und 4 verdeutlicht wird.

Fig. 3 zeigt die Strommesseinrichtung ohne eine obere Abdeckung, sodass der Blick frei wird auf einen ferromagnetischen Körper 18. Dieser übergreift ebenso wie ein darunter angeordneter elastischer Pufferkörper 19 mit zwei Aufnahmeöffnungen 18.1, 18.2 die unteren Abschnitte 12.1, 13.1 der Hauptkontaktanschlüsse 12, 13. Aus Fig. 3 wird dabei ersichtlich, dass die unteren Abschnitte 12.1, 13.1 der Hauptkontaktanschlüsse 12, 13 einen quadratischen Querschnitt aufweisen, während die oberen Abschnitte 12.2, 13.2 einen runden Querschnitt aufweisen. In der Mitte zwischen den beiden Hauptkontaktanschlüssen 12, 13 weist der ferromagnetische Körper 18 eine zentrale Öffnung 20 auf, in der ein Hall-Sensor 21 angeordnet ist.

Wie Fig. 4 verdeutlicht, besteht der ferromagnetische Körper 18 aus einer Vielzahl von ferromagnetischen Blechen 22, die mittels Nieten 23 zusammengehalten werden. Der ferromagnetische Körper 18 wird von oben durch einen Aufnahmedeckel 24 abgedeckt.

Der Aufbau der Strommesseinrichtung 15 ist lediglich beispielhaft.

## Patentansprüche

1. Kontaktanordnung auf einer Leiterplatte (10) mit zwei Hauptkontaktanschlüssen (12, 13), die über eine stromleitende Brücke (14) verbunden sind, und mit einer Strommesseinrichtung (15) zur Messung mindestens des über die Hauptkontaktanschlüsse (12, 13) fließenden Stroms,
wobei die Strommesseinrichtung (15) mindestens einen Hall-Sensor (21) aufweist, und
wobei die Strommesseinrichtung (15) eine Einrichtung zur Ausrichtung des magnetischen Flusses aufweist, die mindestens einen die Hauptkontaktanschlüsse (12,13) umschließenden und mit einem Freiraum (20) für den oder die Hall-Sensor/en (21) versehenen ferromagnetischen Körper (18) aufweist, **dadurch gekennzeichnet, dass**
die Strommesseinrichtung (15) zwischen der stromleitenden Brücke (14) und
der Leiterplatte angeordnet ist, und dass
in der stromleitenden Brücke (14) eine Sicherung (16) angeordnet ist, die den Stromfluss über die Brücke (14) unterbricht, wenn die Stromstärke einen vorgegebenen Maximalwert überschreitet.

2. Kontaktanordnung nach Anspruch 1, **dadurch gekennzeichnet, dass** der ferromagnetische Körper (18) aus einem Stapel von ferromagnetischen Blechen (22) gebildet ist.

3. Kontaktanordnung nach Anspruch 2, **dadurch gekennzeichnet, dass** Maximalwerte für die Stromstärke zwischen 40 A und 500 A betragen.

4. Kontaktanordnung nach einem der vorhergehenden Ansprüche, **dadurch gekennzeichnet, dass** zwischen der Strommesseinrichtung (15) und der Leiterplatte (10) ein elastischer Pufferkörper (19) angeordnet ist.

5. Kontaktanordnung nach einem der vorhergehenden Ansprüche, **dadurch gekennzeichnet, dass** die Hauptkontaktanschlüsse (12, 13) durch Bolzen gebildet sind, die über eine Einpress-Verbindung auf der Leiterplatte (10) befestigt sind.

6. Kontaktanordnung nach Anspruch 5, **dadurch gekennzeichnet, dass** die Bolzen einen gestuften Durchmesser aufweisen, wobei ein unterer Bolzenabschnitt (12.1, 13.1) einen größeren Durchmesser aufweist als ein oberer Abschnitt (12.2, 13.2).

7. Kontaktanordnung nach Anspruch 6, **dadurch gekennzeichnet, dass** die stromleitende Brücke (14) auf den unteren Bolzenabschnitten (12.1, 13.1) aufliegt und die Strommesseinrichtung (15) zwischen den unteren Bolzenabschnitten (12.1, 13.1) angeordnet ist.

8. Kontaktanordnung nach einem der Ansprüche 5 bis 7, **dadurch gekennzeichnet, dass** die Brücke (14) und/oder die Strommesseinrichtung (15) Durchtrittsöffnungen (14.1, 14.2; 18.1, 18.2) zur Aufnahme und Kontaktierung der Bolzen (12, 13) aufweisen.

9. Kontaktanordnung nach einem der vorhergehenden Ansprüche, **dadurch gekennzeichnet, dass** mit der Strommesseinrichtung (15) über die Hauptkontaktanschlüsse (12, 13) fließende Ströme in beide Stromrichtungen messbar sind.

## Claims

1. Contact arrangement on a printed circuit board (10) with two main contact terminals (12, 13) connected via a current-conducting bridge (14), and with a current measuring device (15) for measuring at least the current flowing through the main contact terminals (12, 13),
wherein the current measuring device (15) has at least one Hall sensor (21), and
wherein the current measuring device (15) comprises a device for aligning the magnetic flux, which comprises at least one ferromagnetic body (18) surrounding the main contact terminals (12, 13) and provided with a free space (20) for the Hall sensor(s) (21), **characterized in that**
the current measuring device (15) is arranged between the current-conducting bridge (14) and
the printed circuit board, and **in that** a fuse (16) is arranged in the current-conducting bridge (14), which interrupts the current flow via the bridge (14) when the current exceeds a predetermined maximum value.

2. Contact arrangement according to claim 1, **characterized in that** the ferromagnetic body (18) is formed from a stack of ferromagnetic sheets (22).

3. Contact arrangement according to claim 2, **characterized in that** maximum values for the current intensity are between 40 A and 500 A.

4. Contact arrangement according to one of the preceding claims, **characterized in that** an elastic buffer body (19) is arranged between the current measuring device (15) and the printed circuit board (10).

5. Contact arrangement according to one of the preceding claims, **characterized in that** the main contact connections (12, 13) are formed by bolts which are fastened to the printed circuit board (10) by means of a press-fit connection.

6. Contact arrangement according to claim 5, **characterized in that** the bolts have a stepped diameter, wherein a lower bolt section (12.1, 13.1) has a larger diameter than an upper section (12.2, 13.2).

7. Contact arrangement according to claim 6, **characterized in that** the current-conducting bridge (14) rests on the lower bolt sections (12.1, 13.1) and the current measuring device (15) is arranged between the lower bolt sections (12.1, 13.1).

8. Contact arrangement according to one of claims 5 to 7, **characterized in that** the bridge (14) and/or the current measuring device (15) have through openings (14.1, 14.2; 18.1, 18.2) for receiving and contacting the bolts (12, 13).

9. Contact arrangement according to one of the preceding claims, **characterized in that** currents flowing through the main contact connections (12, 13) can be measured in both current directions with the current measuring device (15).

## Revendications

1. Dispositif de contact sur une carte de circuit imprimé (10) comprenant deux bornes de contact principales (12, 13) reliées par un cavalier conducteur de courant (14) et comprenant un dispositif de mesure de courant (15) permettant de mesurer au moins le courant passant par les bornes de contact principales (12, 13),
dans lequel le dispositif de mesure de courant (15) présente au moins un capteur à effet Hall (21), et
dans lequel le dispositif de mesure de courant (15) présente un dispositif permettant d'orienter le flux magnétique et présentant au moins un corps ferromagnétique (18) qui entoure les bornes de contact principales (12, 13) et est muni d'un espace libre (20) pour le ou les capteur(s) à effet Hall (21), **caractérisé en ce que**
le dispositif de mesure de courant (15) est agencé entre le cavalier conducteur de courant (14) et le circuit imprimé, et **en ce que**
un fusible (16), qui interrompt le passage du courant par le cavalier (14) lorsque l'intensité de courant dépasse une valeur maximale prédéfinie, est agencé dans le cavalier conducteur de courant (14).

2. Dispositif de contact selon la revendication 1, **caractérisé en ce que** le corps ferromagnétique (18) est constitué d'un empilement de tôles ferromagnétiques (22).

3. Dispositif de contact selon la revendication 2, **caractérisé en ce que** les valeurs maximales pour l'intensité de courant sont comprises entre 40 A et 500 A.

4. Dispositif de contact selon l'une quelconque des revendications précédentes, **caractérisé en ce que**
un corps tampon élastique (19) est agencé entre le dispositif de mesure de courant (15) et la carte de circuit imprimé (10).

5. Dispositif de contact selon l'une quelconque des revendications précédentes, **caractérisé en ce que**
les bornes de contact principales (12, 13) sont constituées de pitons qui sont fixés sur la carte de circuit imprimé (10) par connexion insérée à force.

6. Dispositif de contact selon la revendication 5, **caractérisé en ce que** les pitons présentent un diamètre étagé, dans lequel une section de piton inférieure (12.1, 13.1) présente un diamètre supérieur à celui d'une section supérieure (12.2, 13.2).

7. Dispositif de contact selon la revendication 6, **caractérisé en ce que** le cavalier conducteur de courant (14) repose sur les sections de piton inférieures (12.1, 13.1) et le dispositif de mesure de courant (15) est agencé entre les sections de piton inférieures (12.1, 13.1).

8. Dispositif de contact selon l'une quelconque des revendications 5 à 7, **caractérisé en ce que** le cavalier (14) et/ou le dispositif de mesure de courant (15) présente(nt) des orifices de passage (14.1, 14.2 ; 18.1, 18.2) permettant d'accueillir et de mettre en contact les pitons (12, 13).

9. Dispositif de contact selon l'une quelconque des revendications précédentes, **caractérisé en ce que** des courants passant par les bornes de contact principales (12, 13) peuvent être mesurés avec le dispositif de mesure de courant (15) dans les deux sens de courant.
